# EUROPÄISCHE PATENTSCHRIFT

(11) **EP 2 017 548 B1**
(45) Veröffentlichungstag und Bekanntmachung des Hinweises auf die Patenterteilung: **13.10.2010**
(21) Anmeldenummer: 07014323.5
(22) Anmeldetag: 20.07.2007
(51) Int. Cl.: F24H 3/04, F24H 9/18, F24H 9/20

(54) **Elektrische Heizvorrichtung insbesondere für Kraftfahrzeuge**
Electric heating device, in particular for motor vehicles
Dispositif de chauffage électrique, en particulier pour véhicules automobiles

(43) Veröffentlichungstag der Anmeldung: 21.01.2009
(73) Patentinhaber: Eberspächer catem GmbH & Co. KG, 76863 Herxheim bei Landau (DE)
(72) Erfinder: Clade, Michael, 67245 Lambsheim (DE); Bohlender, Franz, 76870 Kandel (DE)
(74) Vertreter: Grünecker, Kinkeldey, Stockmair & Schwanhäusser Anwaltssozietät

(56) Entgegenhaltungen:
- EP-A- 1 338 451

## Beschreibung

Die Erfindung bezieht sich auf eine elektrische Heizvorrichtung zur Lufterwärmung, die sich insbesondere für den Einsatz als elektrische Zusatzheizung in Kraftfahrzeugen eignet.

Für den Einsatz in Kraftfahrzeugen, insbesondere solchen mit verbrauchsoptimierten Motoren, werden elektrische Heizvorrichtungen zur Beheizung des Innenraums und/oder des Motors verwendet. Eine elektrische Zusatzheizung ist insbesondere nach dem Starten des Motors erforderlich, solange der Verbrennungsmotor noch keine ausreichende Wärmeenergie zur Verfügung stellt. Verbrauchsoptimierte Verbrennungsmotoren erfordern sogar grundsätzlich den Einsatz elektrischer Zusatzheizen.

Der Einsatz solcher Heizvorrichtungen ist jedoch nicht auf den Kraftfahrzeugbereich beschränkt, sie sind auch für eine Vielzahl anderer Einsatzzwecke geeignet, beispielsweise im Bereich von Hausinstallationen (Raumklimatisierung), Industrieanlagen und dergleichen.

Aus EP-A1-1 395 098 ist eine elektrische Heizvorrichtung für Kraftfahrzeuge bekannt. Die beschriebene Heizvorrichtung umfasst mehrere zu einem Heizblock zusammengesetzte Heizelemente. Der Heizblock wird zusammen mit einer Steuereinrichtung zur Ansteuerung der Heizelemente in einem gemeinsamen Rahmen gehalten. Die Steuereinrichtung bildet so mit dem in dem Rahmen gehaltenen Heizblock eine bauliche Einheit. Die Steuereinrichtung umfasst eine Leistungselektronik mit elektronischen Schaltern, die jeweils mit einem Kühlkörper versehen sind. Die Steuereinrichtung ist so angeordnet, dass ein Teil des zu erwärmenden Luftstroms die Steuereinrichtung, insbesondere die Kühlelemente, zur Kühlung der elektronischen Schalter anströmt.

Dokument EP-A-1 338 451 offenbart eine elektrische Heizvorrichtung gemäß dem Oberbegriff des Anspruchs 1.

Die elektronischen Schalter, insbesondere in Form von Leistungstransistoren, die den Strom steuern, der den Heizelementen zugeführt wird, sind mit einer Seite direkt auf einer Leiterplatte montiert. Zur Abführung der von den Leistungstransistoren erzeugten Verlustwärme ist auf der gegenüberliegenden Seite der Leiterplatte ein Kühlelement vorgesehen. Ein solches Kühlelement, das direkt den Leistungstransistor kontaktiert, kann die Verlustwärme des Leistungstransistors auf einfache Weise und in ausreichender Menge abführen.

Als Kühlelement kommt bei dem vorerwähnten Stand der Technik ein U-förmig gestalteter Kühlkörper zum Einsatz mit Kühlrippen bzw. Fingern, die von einer Grundfläche abstehen. An der Unterseite des Kühlkörpers ist ein Zapfen vorgesehen, der in die Leiterplatte zur Kontaktierung des Leistungstransistors einsetzbar ist. Ein Kühlelement im Sinne der vorliegenden Erfindung kann jedoch jedes beliebige Bauteil sein, welches geeignet ist, Wärme durch Wärmeleitung von den Leistungstransistoren abzuführen und wirksam durch Wärmeübertragung an umströmende Luft abzugeben. Hierzu wird das Kühlelement derjenigen Luft ausgesetzt, die durch die elektrische Heizvorrichtung erwärmt werden soll, d.h. in einem zu der elektrischen Heizvorrichtung geführten Kanal strömt. Es ist jedoch nicht auszuschließen, dass sich in dem Kanal Feuchtigkeit sammelt, die entweder direkt mit der einströmenden Luft eingetragen oder aus der eingeströmten Luft kondensiert.

Aufgabe der vorliegenden Erfindung ist es daher, eine elektrische Heizvorrichtung der eingangs genannten Art dahingehend weiterzubilden, dass diese einfach herzustellen und die Steuereinrichtung der elektrischen Heizvorrichtung zuverlässig vor eindringender Feuchtigkeit geschützt werden kann.

Zur Lösung dieser Aufgabe wird mit der vorliegenden Erfindung eine elektrische Heizvorrichtung mit den Merkmalen von Anspruch 1 angegeben. Diese unterscheidet sich von dem gattungsbildenden Stand der Technik dadurch, dass die Steuereinrichtung an einem Steuereinrichtungsträger gehalten ist und dass zwischen dem Steuereinrichtungsträger und einem den Heizblock aufnehmenden Heizblockgehäuse Dichtelemente vorgesehen sind, die von den Kontakt- bzw. Kühlelementen durchragt und durch Klemmung zwischen dem Steuereinrichtungsträger und dem Heizblockgehäuse abgedichtet sind.

Bei der erfindungsgemäßen elektrischen Heizvorrichtung ist die bauliche Einheit dadurch hergestellt, dass der Steuereinrichtungsträger mit dem Heizblockgehäuse verbunden ist. Die Kontaktelemente, welche für eine Versorgung des Heizblockes mit elektrischen Strom sorgen, so wie die, die Kühlung der elektronischen Schalter bewirkenden Kühlelemente erstrecken sich zwischen dem Steuereinrichtungsträger und dem Heizblockgehäuse. Die Kontakt- bzw. Kühlelemente durchragen jeweils indes wenigstens ein Dichtelement. Die Dichtigkeit des Dichtelementes wird dadurch hervorgerufen, dass das Dichtelement zwischen dem Steuereinrichtungsträger und dem Heizblockgehäuse geklemmt wird. Dadurch ist es möglich, die Dichtelemente zunächst spannungsfrei zu montieren und erst bei der Erstellung der baulichen Einheit von Steuereinrichtung und Heizblock, d.h. beim Verbinden des Steuereinrichtungsträgers mit dem Heizblockgehäuse, die jeweiligen Dichtelemente zur dichtenden Anlage zu klemmen. Die erfindungsgemäße elektrische Heizvorrichtung lässt sich dadurch auf einfache Weise herstellen, ohne auf eine zuverlässige Abdichtung der Steuereinrichtung verzichten zu müssen.

Besonders einfach und daher wirtschaftlich kann die erfindungsgemäße elektrische Heizvorrichtung hergestellt werden, wenn das bzw. die Kühlelemente als stift- bzw. blattförmige Vollkörper ausgebildet sind, die zur Anbindung an den elektronischen Schalter (z.B. Leistungstransistor) durch die Leiterplatte hindurchgeführt sind und die an der dem elektronischen Schalter abgewandten Unterseite der Leiterplatte diese überragen. Im Anlagebereich mit dem Dichtelement können sowohl an dem bzw. den Kühlelementen wie auch dem/den Kontaktelementen Dicht- bzw. Anlageflächen für die Dichtelemente vorgesehen sein, die von einer zylindrischen und damit der einfachen Form abweichen. Solche Ausgestaltungen sind insbesondere im Hinblick auf eine radiale Klemmung der Dichtelemente gegen die Innenumfangsfläche der Kontakt- bzw. Kühlelemente zu bevorzugen. Alternativ kann der Steuereinrichtungsträger und/oder das Heizblockgehäuse konische Aufnahmen für die Dichtelemente aufweisen, die die Durchtrittsöffnungen für die Kontakt- bzw. Kühlelemente umgeben. Zur Erzeugung einer dichtenden Anlage der Dichtelemente an der Innenumfangsfläche der Durchtrittsöffnungen einerseits und dem Außenumfang der Kontaktelemente bzw. der Kühlelemente andererseits sind die Dichtelemente zwischen dem Heizblockgehäuse und dem Steuereinrichtungsträger vorzugsweise axial, d.h. in Längsrichtung der Kühl- bzw. Kontaktelemente festgelegt. Bei der Fertigstellung der baulichen Einheit bestehend aus dem Heizblockgehäuse und dem Steuereinrichtungsträger werden die von den Kontakt- bzw. Kühlelementen durchragten Dichtelemente in Längsrichtung dieser Elemente komprimiert, was zu einer dichtenden Anlage in radialer Richtung führt.

Bei elektrischen Heizvorrichtungen der vorstehend genannten Art können mehrere elektronische Schalter vorgesehen sein. Auch sind üblicherweise mehr als zwei Kontaktelemente zur Versorgung der einzelnen Heizelemente vorgesehen, welche zweckmäßigerweise an derjenigen Stirnseite das Heizblockgehäuse überragen, an der sich der Steuereinrichtungsträger befindet. Im Hinblick auf eine möglichst einfache Montage der elektrischen Heizvorrichtung wird gemäß einer weiteren bevorzugten Ausgestaltung der vorliegenden Erfindung vorgeschlagen, die Dichtelemente zur Ausbildung einer integralen Dichteinheit miteinander zu verbinden. Diese integrale Dichteinheit kann bei der Montage beispielsweise dadurch vorfixiert werden, dass die Dichteinheit auf die das Heizblockgehäuse überragenden Kontaktelemente aufgeschoben wird. Auf diese Weise werden auch die Dichtelemente für die Kühlelemente an dem Heizblockgehäuse in eine vorbestimmte Lage gebracht, die der Position der Kühlelemente entspricht, wenn der Steuereinrichtungsträger mit dem Heizblockgehäuse verbunden ist. Die Dichteinheit kann als Spritzgießteil aus einem wärmebeständigen thermoplastischen Elastomer hergestellt werden. Ein solches Spritzgießteil kann beispielsweise auch als Einlegeteil in eine Spritzgießform eingelegt werden, die der Herstellung des Steuereinrichtungsträgers oder des Heizblockgehäuses bzw. einer Gehäusehälfte desselben dient. Auf diese Weise können die Fügeschritte zur Herstellung der Heizvorrichtung reduziert werden.

Sofern die Dichteinheit indes als Einlegeteil ausgebildet ist, welches separat montiert wird, ist es zu bevorzugen, die Dichtelemente durch einen Basisabschnitt miteinander zu verbinden. Zur Erhöhung der Dichtigkeit kann es zu bevorzugen sein, diesen Basisabschnitt an dem Rand der Durchtrittsöffnungen dichtend zwischen dem Heizblockgehäuse und dem Steuereinrichtungsträger zu klemmen. Hierdurch wird zusätzlich zu einer eventuell vorhandenen radialen Abdichtung, die durch die Dichtelemente selbst bewirkt wird, eine rechtwinklig hierzu wirkende Abdichtung geschaffen. Zur Erzeugung möglichst hoher Klemmkräfte ist es weiterhin zu bevorzugen, einen vorspringenden Kragen vorzusehen, der gehäuseseits die Aufnahmen für die Dichtelemente umgibt. Im Hinblick auf eine möglichst einfache Ausbildung des Heizblockgehäuses ist es hierbei zu bevorzugen, diesen vorspringenden Kragen an dem Steuereinrichtungsträger vorzusehen, der aus gleichem Grund auch die konischen Aufnahmen für die Dichtelemente aufweisen sollte.

Zur Verbesserung der Abdichtung wird gemäß einer weiteren bevorzugten Ausgestaltung der vorliegenden Erfindung vorgeschlagen, das Dichtelement zu jedem der Kontakt- bzw. Kühlelemente mit mehreren in Längsrichtung, bezogen auf diese Kontakt- bzw. Kühlelemente hintereinander angeordneten Dichtanlageflächen auszubilden. Diese sind vorzugsweise konisch gestuft zueinander angeordnet und vorzugsweise durch hintereinander angeordnete Dichtwülste vorgegeben. Bei der letztgenannten bevorzugten Ausgestaltung liegen die Dichtwülste in Längsrichtung der Kontakt- bzw. Kühlelemente voneinander beabstandet, wobei vorzugsweise das die jeweiligen Dichtwülste miteinander verbindende Material der Dichtelemente eine Art Filmscharnier ausbildet, das eine gewisse Beweglichkeit der einzelnen Dichtwülste zueinander in Längsrichtung der Kontakt- bzw. Kühlelemente ermöglicht.

Dies fördert die dichtende Anlage der einzelnen Dichtanlageflächen an den Kontakt- bzw. Kühlelementen und den Durchtrittsöffnungen bzw. den konischen Aufnahmen.

Zur genauen Fixierung der Dichtelemente bzw. der Dichteinheit bei der Montage der elektrischen Heizvorrichtung wird gemäß einer weiteren bevorzugten Ausgestaltung der vorliegenden Erfindung vorgeschlagen, einen an dem Heizblockgehäuse ausgebildete Fensteröffnungen überdeckenden Quersteg an dem Heizblockgehäuse vorzusehen, der eine Anlagefläche für den Basisabschnitt des Dichtelementes ausbildet und hierdurch zunächst die Abdichtung verbessert. Hierzu bildet der Quersteg zweckmäßigerweise eine im Wesentlichen ebene Anlagefläche für den Basisabschnitt aus. Der Quersteg hat aber gemäß einer weiteren bevorzugten Ausgestaltung der vorliegenden Erfindung ferner Zentrieraufnahmen, in denen an dem Basisabschnitt ausgebildete Zentriervorsprünge aufgenommen sind. Diese Zentriervorsprünge befinden sich vorzugsweise auf der den Dichtelementen abgewandten Unterseite des Basisabschnitts. Diese Unterseite wird auf die ebene Anlagefläche aufgelegt, wodurch aufgrund der Zentrieraufnahmen eine lagegenaue Positionierung der Dichteinheit bewirkt wird, die auch das Einführen der Kontakt- bzw. Kühlelemente bei der weiteren Montage der elektrischen Heizvorrichtung begünstigt. Hierzu umgeben die Zentrieraufnahmen vorzugsweise die Durchtrittsöffnungen für das bzw. die Kühl- und/oder das Kontaktelement(e).

Die bauliche Einheit zwischen der Steuereinrichtung und dem Heizblock wird vorzugsweise dadurch hergestellt, dass das Heizblockgehäuse mit einem Steuereinrichtungsgehäuse verbunden ist, welches den Steuereinrichtungsträger umfasst. Das Steuereinrichtungsgehäuse hat einen Gehäusedeckel, welches wenigstens eine Schnittstelle für die Versorgung und Steuerung der Heizvorrichtung umfasst. Das Steuereinrichtungsgehäuse umgibt ferner eine Leiterplatte mit im Wesentlichen rechtwinklig davon abgehenden Kühlelementen und elektronischen Schaltern. Das Steuereinrichtungsgehäuse soll insbesondere einen gewissen mechanischen Schutz der Steuereinrichtung bewirken. Es ist nicht zwingend erforderlich, dass dieses Steuereinrichtungsgehäuse die Steuereinrichtung flüssigkeitsdicht abdichtet. Das Steuereinrichtungsgehäuse dient insbesondere dem elektrischen Anschluss der elektrischen Heizvorrichtung sowie gegebenenfalls der Befestigung der Steuereinrichtung bzw. der gesamten Heizvorrichtung.

Zur leichten Herstellung der baulichen Einheit ist es jedoch zu bevorzugen, die in dem Steuereinrichtungsgehäuse aufgenommen und elektrisch in Verbindung stehenden Teile in Längsrichtung der Kontakt- bzw. Kühlelemente aufeinander zu pressen. Hierzu weist der Gehäusedeckel vorzugsweise eine Kontaktschiene auf, die mit wenigstens einer der Schnittstellen sowie der Leiterplatte elektrisch verbunden und auf die Leiterplatte aufgesetzt wird, worunter verstanden werden sollte, dass sich die Kontaktschiene im Wesentlichen rechtwinklig zu der Ebene der Leiterplatte erstreckt. Die Leiterplatte hat ferner mit den Kontaktelementen zusammenwirkende Federzungen. Diese Federzungen sind elektrisch mit Leiterbahnen der Leiterplatte verbunden, wobei die Federzungen derart bemessen sind, dass die an den Federzungen anliegenden Kontaktelemente sicher mit der Leiterplatte elektrisch verbunden werden. Diese Verbindung wird üblicherweise beim Einführen der Kontaktelemente in die an dem Steuereinrichtungsträger ausgesparten Durchtrittsöffnungen bewirkt. Die fest an der Leiterplatte montierten Kühlelemente treten hierbei durch Durchtrittsöffnungen hindurch, die an dem Heizblockgehäuse, vorzugsweise dem Quersteg ausgespart sind. Am Ende dieser Einführbewegung werden die Dichtelemente zwischen dem Steuereinrichtungsträger und dem Heizblockgehäuse geklemmt.

Die so hergestellte bauliche Einheit wird vorzugsweise dadurch gesichert, dass der Steuereinrichtungsträger bzw. das Steuereinrichtungsgehäuse mit dem Heizblockgehäuse verrastet ist.

Weitere vorteilhafte Ausgestaltungen der vorliegenden Erfindung sind in den Unteransprüchen angegeben.

Die vorliegende Erfindung wird nachstehend anhand eines Ausführungsbeispiels in Verbindung mit der Zeichnung beschrieben. In dieser zeigen:
- Figur 1: eine perspektivische Explosionsdarstellung eines Ausführungsbeispiels einer erfindungsgemäßen elektrischen Heizvorrichtung;
- Figur 2: eine Längsschnittansicht eines gegenüber Figur 1 modifizierten Ausführungs- beispiels im zusammengebauten Zustand; und
- Figur 3: ein vergrößertes Detail der in Figur 2 gezeigten Längsschnittansicht an der Phasengrenze zwischen dem Heizblockgehäuse und dem Steuereinrich- tungsgehäuse.

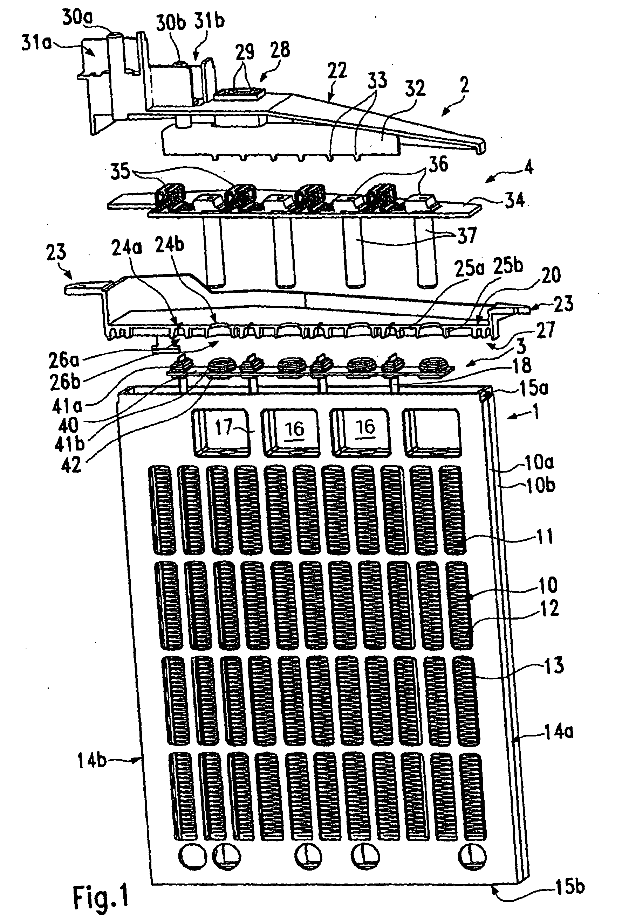

In Figur 1 ist eine perspektivische Explosionszeichnung im Wesentlichen in Form einer Seitenansicht eines Ausführungsbeispiels der erfindungsgemäßen elektrischen Heizvorrichtung gezeigt. Diese weist als wesentliche Elemente ein Heizblockgehäuse 1 sowie ein Steuereinrichtungsgehäuse 2 auf. Zwischen den beiden Gehäusen 1, 2 ist eine Dichteinheit 3 vorgesehen. Das Steuereinrichtungsgehäuse 2 umgibt eine Steuereinrichtung 4.

Das Heizblockgehäuse 1 besteht aus zwei im Wesentlichen identischen Rahmenhälften 10a, 10b, die vorliegend als Kunststoffspritzgussteil ausgebildet sind und an deren Oberfläche eine versteifende Gitterstruktur ausgebildet ist. Zwischen den Gitterstrukturen der beiden Rahmenhälften 10a, 10b ist ein Heizblock 11, bestehend aus einer Mehrzahl von geschichteten oder gestapelten Heizelementen 12 angeordnet. Jedes der Heizelemente 12 besteht aus einem oder mehreren Widerstandsheizelementen, welche in der Darstellung gemäß Figur 1 hinter den Längsstreben des Versteifungsgitters verdeckt liegen, sowie benachbart hierzu angeordneten Radiatoren 13, die vorliegend durch mäandrierend gefaltete Blechbahnen gebildet sind. Im Hinblick auf eine gute Wärmeübertragung und Anlage der Radiatoren 13 an den Widerstandsheizelementen, die vorzugsweise durch so genannte PTC-Elemente gebildet werden, befindet sich zwischen den PTC-Elementen und den Radiatoren 13 eines Heizelementes 12 ein ebener Blechstreifen.

Der Heizblock 11 aus den Heizelementen 12 wird in dem durch die beiden Rahmenhälften 10a, 10b gebildeten Rahmen 10 gehalten. Hierzu weist der Rahmen 10 längliche Längsholme 14a, 14b und sich rechtwinklig hierzu erstreckende Seitenholme 15a, 15b auf.

Zwischen dem in Figur 1 oberen Seitenholm 15a und dem Heizblock 11 sind bei dem gezeigten Ausführungsbeispiel Fensteröffnungen 16 ausgespart. Die benachbarten Fensteröffnungen 16 trennenden Längsstege 17 umgeben ein freies Ende der zwischen den Radiatoren 13 und den Widerstandsheizelementen angeordneten Blechstreifen, die sich nach außen zur Ausbildung einer Kontaktzunge 18 fortsetzen. Die Kontaktzungen 18 überragen den in Figur 1 oberen Rand des Rahmens 10.

Das Steuereinrichtungsgehäuse 2 ist im Wesentlichen zweiteilig ausgebildet mit einem einen Steuereinrichtungsträger 20 umfassenden Gehäuseunterteil 21 und einem hierauf aufgesetzten Gehäusedeckel 22. Das Gehäuseunterteil 21 ist im Wesentlichen wannenförmig ausgebildet und hat an seinen jeweiligen Stirnseiten Befestigungsflansche 23 zur Montage der elektrischen Heizvorrichtung an einem Chassis eines Kraftfahrzeuges. Der Boden des Gehäuseunterteiles 21 bildet den Steuereinrichtungsträger 20 aus, dessen zur Innenseite des Steuereinrichtungsgehäuses 2 zeigende Oberfläche vollkommen eben ist. Der Steuereinrichtungsträger 20 hat mehrere geschlitzte erste Durchtrittsöffnungen 24a, die alternierend mit runden Durchtrittsöffnungen 24b und in Längsrichtung des Steuereinrichtungsträgers 20 hintereinander angeordnet sind.

Die ersten Durchtrittsöffnungen 24a mit rechteckigem Querschnitt sind in Längs- und Querrichtung des Steuereinrichtungsträgers 20 in Richtung auf das Steuereinrichtungsgehäuse 2 konisch zulaufend ausgebildet. In gleicher Richtung konisch zulaufend ausgebildet sind die zweiten Durchtrittsöffnungen 24b mit runder Querschnittsfläche. Auf der dem Innenraum des Steuereinrichtungsgehäuses abgewandten Unterseite des Steuereinrichtungsträgers 20 befinden sich erste und zweite Kragen 25a, 25b, deren Querschnittsform der Form der Durchtrittsöffnungen 24 entspricht. Diese Kragen 25a, 25b bilden den überwiegenden Teil innerer Seitenwände von konisch zulaufenden Aufnahmen 26a, 26b aus. Der Steuereinrichtungsträger 20 wird von einer zur Unterseite hin offenen Doppelnut 27 umkränzt, die derart ausgebildet ist, dass der stirnseitige Rand des Heizblockgehäuses 1 in die Innere der Doppelnuten 27 passt.

Der Gehäusedeckel 22 bildet eine Steckaufnahme 28 aus, in dem elektrische Steuerkontakte 29 aufgenommen sind. Ferner weist der Gehäusedeckel 22 zwei elektrische Versorgungsschnittstellen 30a, 30b auf, die durch aufstehende Wandungen voneinander abgeschirmt sind, die Versorgungssteckaufnahmen 31 a, 31 b ausbilden. Die elektrische Versorgungsschnittstelle 30b ist elektrisch an einer Kontaktschiene 32 angeschlossen, die durch ein elektrisch leitendes Blech gebildet ist, welches an seiner dem Steuereinrichtungsträger 20 zugewandten Stirnseite mehrere Kontakte 33 aufweist. Analog hierzu sind die Steuerungskontakte 32 mit einer hinter der Kontaktschiene 32 verdeckt vorgesehenen weiteren Steuerkontaktschiene elektrisch miteinander verbunden, welche ebenfalls an seiner Stirnseite Kontaktzapfen ausformt.

Zwischen dem Gehäuseunterteil 21 und dem Gehäusedeckel 22 befindet sich die Steuereinrichtung 4, die eine Leiterplatte 34 umfasst, auf deren Oberseite in Längsrichtung alternierend vier doppelt wirkende Federzungen 35 und vier Leistungstransistoren 36 kontaktiert angeordnet sind. Die Leistungstransistoren 36 sind mit zylindrischen Kühlelementen 37 verbunden, die durch in der Leiterplatte 34 ausgesparte Öffnungen hindurchgeführt sind und die Unterseite der Leiterplatte 34 überragen. Die zylindrischen Kühlelemente 37 fluchten mit den zweiten Durchtrittsöffnungen 24b und den korrespondierend hierzu ausgebildeten Aufnahmen 26b.

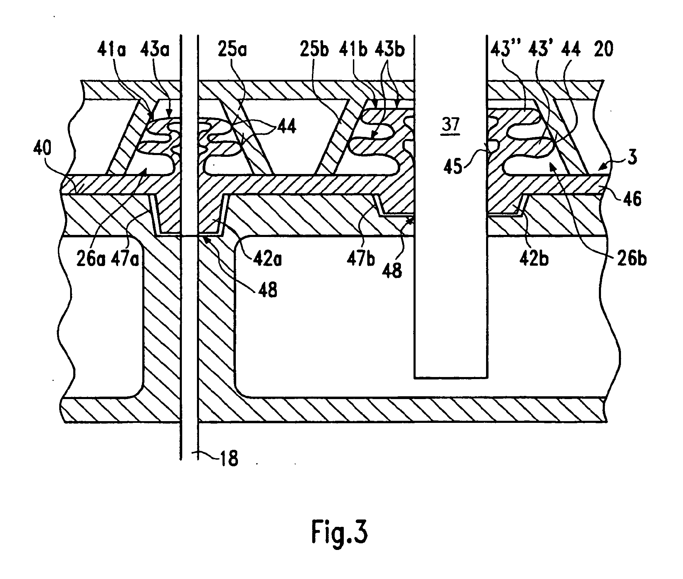

Die Dichteinheit 3 ist aus einem wärmebeständigen, elastischen Material, vorliegend aus EPOM gebildet und als einteiliges Bauteil, beispielsweise mittels Spritzgießen oder Gießen, ausgeformt und umfasst einen bandförmigen Basisabschnitt 40, dessen zu dem Steuereinrichtungsgehäuse 2 zeigende Oberseite von ersten und zweiten Dichtelementen 41 a, 41 b überragt ist. Korrespondierend hierzu weist die Unterseite des Basisabschnittes 40 Zentriervorsprünge 42 auf. Jedes der Dichtelemente 41 besteht aus zwei in Längsrichtung der Kühlelemente 37 bzw. der Kontaktzungen 18 hintereinander angeordneten ersten und zweiten Dichtwülsten 43a, 43b. Die ersten Dichtwülste 43a weisen eine rechteckige Grundfläche mit einer korrespondierend hierzu ausgebildeten Ausnehmung, die zweiten Dichtwülste 43b eine entsprechend ausgebildete kreisrunde Grundform auf. Der benachbart zu dem Basisabschnitt 40 angeordnete unterer Dichtwulst 43' hat größere Abmessungen als der darüber liegende Dichtwulst 43". Jeder der Dichtwülste 43 bildet an seiner äußeren Umfangsfläche umlaufende Dichtanlageflächen 44 aus, die aufgrund der abgestuften Anordnung der Dichtwülste 43a, 43b zu einer konischen Ausbildung der durch das jeweilige Dichtelement 41 a, 41 b gebildeten äußeren Dichtfläche führen (vgl. Figur 3). Der Innenumfang der jeweiligen Dichtwülste 43a, 43b ist im Wesentlichen konstant, so dass die durch die Wülste 43a, 43b innen gebildete innere Dichtanlagefläche 45 einen zylindrischen Verlauf hat.

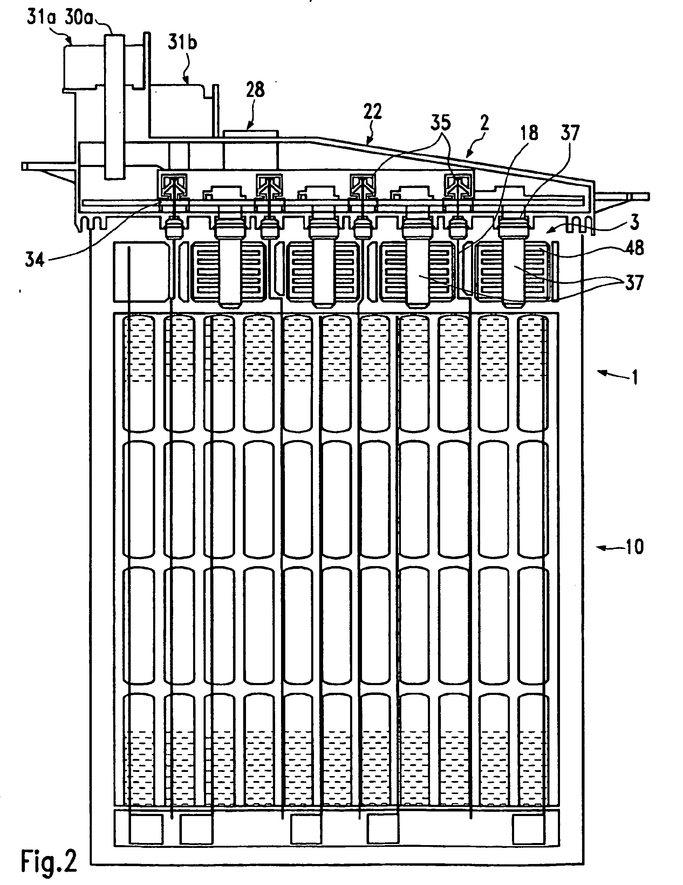

Zur Montage des in den Figuren gezeigten Ausführungsbeispiels werden beispielsweise zunächst das Heizblockgehäuse 1 sowie das Steuereinrichtungsgehäuse 2 mit den darin aufgenommenen Heiz- und Steuerelementen komplett vorbereitet. Zum Fügen der drei wesentlichen Elemente, Heizblockgehäuse 1, Steuereinrichtungsgehäuse 2 und Dichteinheit 3 wird beispielsweise die Dichteinheit 3 heizblockseitig vormontiert. Hierzu werden die ersten Dichtelemente 41 a so weit auf die Kontaktzungen 18 soweit aufgeschoben, dass der Basisabschnitt 40 auf einem in Figur 2 dargestellten und die Fensteröffnungen 16 oberseitig abdeckenden Quersteg 46 aufliegt, welcher Zentrieraufnahmen 47a, 47b für die Zentriervorsprünge 42 sowie zu den Fensteröffnungen 16 führende Durchtrittsöffnungen 48 für die Kühlelemente 37 ausspart. Danach wird das vormontierte Steuereinrichtungsgehäuse 2 mit dem Heizblockgehäuse 1 zur Ausbildung einer baulichen Einheit verbunden. Die Kühlelemente 37 werden hierzu fluchtend in die zugeordneten Dichtelemente 41 b eingeführt und soweit eingeschoben, bis der obere Rand des Heizblockgehäuses 1 in der inneren Doppelnut 27 aufgenommen ist. Bei dieser Bewegung treten die jeweiligen Dichtelemente 41 a, 41 b jeweils in die zugeordneten Aufnahmen 26a, 26b ein, werden aufgrund der konischen Ausgestaltungen zentriert und schließlich in radialer Richtung komprimiert, da der Basisabschnitt 40 durch Anlage an dem Quersteg 46 die Dichteinheit 3 fixiert. Zeitgleich werden die freien Enden der Kontaktzungen 18 durch die Durchtrittsöffnungen 24a in das Innere des Steuereinrichtungsgehäuses 2 und zwischen die doppelt wirkenden Federzungen 35 geschoben, wodurch ein elektrischer Kontakt zwischen den Federzungen 35 und den Kontaktzungen 18 hergestellt wird.

Am Ende der Einschiebbewegung hat sich ein mit der Einschiebebewegung zunehmender radialer Druck auf die Dichtelemente 41 a, 41 b aufgebaut, die nunmehr dichtend an der Innenumfangsfläche der Aufnahme 26 einerseits und dem Außenumfang der Kontaktzungen 18 bzw. der Kühlelemente 37 anliegen. Bei dem gezeigten Ausführungsbeispiel besteht ferner die Besonderheit, dass die Höhe der Kragen 25a, 25b so gewählt ist, dass die Kragen 25a, 25b stirnseitig gegen den Basisabschnitt 40 anliegen, die so in Längsrichtung der Kühlelemente 37 bzw. der Kontaktzungen 18 zwischen dem Quersteg 46 und den Stirnseiten der Kragen 25 abdichtend geklemmt ist.

Bei der so erstellten baulichen Einheit sind die Steuerkontakte 29 über die Steuerkontaktschiene mit der Leiterplatte 34 kontaktiert, deren entsprechende Leiterbahnen an den Leistungstransistoren 36 angeschlossen sind. Die Kontaktzapfen 33 kontaktieren an der Leiterplatte 34 vorgesehene Kontaktstellen, die zu den Leistungstransistoren 36 führen und abhängig von der Schaltcharakteristik der Leistungstransistoren 36 auf die Federzungen 35 und damit auf die Kontaktzungen 18 aufgeschaltet werden können. Die elektrische Versorgungsschnittstelle 30a für Masse ist über an dem Steuereinrichtungsgehäuse ausgeformte elektrische Leiterbahnen im Bereich der Doppelnut 27 elektrisch an das Heizblockgehäuse 1 angeschlossen. Die Kühlelemente 37 befinden sich mit ihrem vorderen Ende in den jeweiligen Fensteröffnungen 16.

Die Verbindung zwischen dem Heizblockgehäuse 1 und dem Steuereinrichtungsgehäuse 2 kann auf verschiedene Weise gesichert werden, insbesondere durch Verschweißen oder Verkleben. Das in den Figuren gezeigte Ausführungsbeispiel eignet sich besonders für eine kostengünstige Herstellung der elektrischen Heizvorrichtung, da das Gehäuseunterteil 21 sowie der Gehäusedeckel 22 des Steuereinrichtungsgehäuses 2, wie auch die beiden Gehäusehälften 10a, 10b mittels Spritzgießen hergestellt werden können. Die Dichteinheit 3 wird als separat von diesem Gehäuse hergestelltes Einlegeteil bei der Montage mit den Gehäusen 1, 2 verbunden.

Das in Figur 2 gezeigte Ausführungsbeispiel unterscheidet sich lediglich dadurch von dem in Figur 1 dargestelltem, das in den Fensteröffnungen 16 geschlitzte Wärmeleitbleche 49 vorgesehen sind, die an das vordere Ende der Kühlelemente angeklipst sind.

### Bezugszeichenliste

- 1: Heizblockgehäuse
- 2: Steuereinrichtungsgehäuse
- 3: Dichteinheit
- 4: Steuereinrichtung
- 10: Rahmen
- 10a,b: Gehäusehälfte
- 11: Heizblock
- 12: Heizelement
- 13: Radiator
- 14a,b: Längsholm
- 15a,b: Seitenholm
- 16: Fensteröffnung
- 17: Längssteg
- 18: Kontaktzunge
- 20: Steuereinrichtungsträger
- 21: Gehäuseunterteil
- 22: Gehäusedeckel
- 23: Befestigungsflansch
- 24a,b: Durchtrittsöffnung
- 25a,b: Kragen
- 26a, b: Aufnahme
- 27: Doppelnut
- 28: Steckaufnahme
- 29: Steckkontakt
- 30a,b: elektrische Versorgungsschnittstelle
- 31 a,b: Versorgungssteckaufnahme
- 32: Kontaktschiene
- 33: Kontaktzapfen
- 34: Leiterplatte
- 35: Federzunge
- 36: Leistungstransistor
- 37: Kühlelement
- 40: Basisabschnitt
- 41 a,b: Dichtelement
- 42: Zentriervorsprünge
- 43a,b: Dichtwulst
- 43': unterer Dichtwulst
- 43": oberer Dichtwulst
- 44: äußere Dichtanlagefläche
- 45: innere Dichtanlagefläche
- 46: Quersteg
- 47a,b: Zentrieraufnahme
- 48: Durchtrittsöffnung
- 49: Wärmeleitbleche

## Patentansprüche

1. Elektrische Heizvorrichtung, insbesondere als Zusatzheizung für Kraftfahrzeuge, mit mehreren zu einem Heizblock (11) zusammengesetzten Heizelementen (12), einer Steuereinrichtung (4) zur Ansteuerung der Heizelemente (12), wobei die Steuereinrichtung (4) mit dem Heizblock (11) eine bauliche Einheit bildet, und sich zwischen der Steuereinrichtung (4) und dem Heizblock (11) erstreckenden Kontakt- und/oder Kühlelementen (18; 37),
**dadurch gekennzeichnet, dass**
die Steuereinrichtung (4) an einem Steuereinrichtungsträger (20) gehalten ist und dass zwischen dem Steuereinrichtungstrager (20) und einem den Heizblock (11) aufnehmenden Heizblockgehäuse (1) Dichtelemente (41) vorgesehen sind, die von den Kontakt- bzw. Kühlelementen (18; 37) durchragt und durch Klemmung zwischen dem Steuereinrichtungsträger (20) und dem Heizblockgehäuse (1) abgedichtet sind.

2. Elektrische Heizvorrichtung nach Anspruch 1, **dadurch gekennzeichnet, dass** die Dichtelemente (41) durch radiale Klemmung gegen die Umfangsfläche der Kontakt- bzw. Kühlelemente (18; 37) anliegen.

3. Elektrische Heizvorrichtung nach einem der vorherigen Ansprüche, **dadurch gekennzeichnet,** der Steuereinrichtungsträger (20) und/oder das Heizblockgehäuse (1) konische Aufnahmen (26) für die Dichtelemente (41) aufweist, die Durchtrittsöffnungen (24) für die Kontakt- bzw. Kühlelemente (18; 37) umgeben, und dass die Dichtelemente (41) zur Erzeugung einer dichtenden Anlage an der Innenumfangsfläche der Aufnahmen (26) und dem Außenumfang der Kontakt- bzw. Kühlelemente (18; 37) zwischen dem Heizblockgehäuse (1) und dem Steuereinrichtungsträger (20) festgelegt sind.

4. Elektrische Heizvorrichtung nach einem der vorherigen Ansprüche, **dadurch gekennzeichnet, dass** die Dichtelemente (41) zur Ausbildung einer integralen Dichteinheit (3) miteinander verbunden sind.

5. Elektrische Heizvorrichtung nach Anspruch 4, **dadurch gekennzeichnet, dass** die Dichtelemente (41) durch einen Basisabschnitt (40) miteinander verbunden sind.

6. Elektrische Heizvorrichtung nach Anspruch 5, **dadurch gekennzeichnet, dass** der Basisabschnitt (40) an dem Rand der Durchtrittsöffnungen (24) dichtend zwischen dem Heizblockgehäuse (1) und dem Steuereinrichtungsträger (20) geklemmt ist.

7. Elektrische Heizvorrichtung nach Anspruch 3, **dadurch gekennzeichnet, dass** die konischen Aufnahmen (26) von einem vorspringenden Kragen (25) umgeben sind.

8. Elektrische Heizvorrichtung nach einem der vorherigen Ansprüche, **dadurch gekennzeichnet, dass** das Dichtelement (41) mehrere in Längsrichtung des Kontakt- bzw. Kühlelementes (18; 37) hintereinander angeordnete Dichtanlageflächen (44) ausbildet, die konisch gestuft zueinander angeordnet sind:

9. Elektrische Heizvorrichtung nach Anspruch 8, **dadurch gekennzeichnet, dass** die Dichtanlageflächen (44) durch hintereinander angeordnete Dichtwülste (43) gebildet sind.

10. Elektrische Heizvorrichtung nach einem der vorheriges Ansprüche, **dadurch gekennzeichnet, dass** das Heizblockgehäuse (1) zwischen dem Heizblock (11) und der Steuereinheit (4) zu den Seitenflächen des Heizblockgehäuses (1) Fensteröffnungen (16) für die Kühlelemente ausbildet, die von einem eine Anlagefläche für den Basisabschnitt (40) ausbildenden Quersteg (46) überdeckt sind.

11. Elektrische Heizvorrichtung nach Anspruch 10, **dadurch gekennzeichnet, dass** der Quersteg (46) eine im Wesentlichen ebene Anlagefläche für den Basisabschnitt (40) ausbildet.

12. Elektrische Heizvorrichtung nach Anspruch 10 oder 11, **dadurch gekennzeichnet, dass** der Quersteg (46) Zentrieraufnahmen (47) ausbildet, in denen an dem Basisabschnitt (40) ausgebildete Zentriervorsprünge (42) aufgenommen sind.

13. Elektrische Heizvorrichtung nach Anspruch 12, **dadurch gekennzeichnet, dass** die Zentrieraufnahmen (47) die Durchtrittsöffnung (48) für das Kühl- und/oder das Kontaktelement (18; 37) umgeben.

14. Elektrische Heizvorrichtung nach einem der vorherigen Ansprüche, **dadurch gekennzeichnet, dass** der Steuereinrichtungsträger (20) Teil eines Steuereinrichtungsgehäuses (2) ist, das wenigstens eine Schnittstelle (29; 31) für die Versorgung und Steuerung der Heizvorrichtung aufweisenden Gehäusedeckel (22) umfasst, und eine Leiterplatte (34) mit im Wesentlichen rechtwinklig davon abgehenden Kühlelementen (37) und elektronischen Schaltern (36) umgibt und mit dem Heizblockgehäuse (1) verbunden ist.

15. Elektrische Heizvorrichtung nach Anspruch 14, **dadurch gekennzeichnet, dass** der Gehäusedeckel (22) eine Kontaktschiene (32) aufweist, die mit wenigstens einer der Schnittstellen (30b) sowie derrteiterplatte (34) elektrisch verbunden und auf die Leiterplatte (34) aufgesetzt ist, dass die Leiterplatte (34) mit den Kontaktelementen (18) zusammenwirkende Federzungen (35) umfasst und dass das Steuereinrichtungsgehäuse (2) durch Einführen der Kühl- und Kontaktelemente (18; 37) in die Durchtrittsöffnungen (24) an dem Heizblockgehäuse (1) unter Klemmung der Dichtelemente (41) montiert ist.

16. Elektrische Heizvorrichtung nach einem der vorherigen Ansprüche, **dadurch gekennzeichnet, dass** der Steuereinrichtungsträger (20) mit dem Heizblockgehäuse (1) verrastet ist.

17. Elektrische Heizvorrichtung nach einem der vorherigen Ansprüche, **dadurch gekennzeichnet, dass** das Dichtelement (41) aus einem wärmebeständigen, elastischen Material, insbesondere EPOM oder Silikon gebildet ist.

## Claims

1. Electric heating device, in particular as a supplementary heating system for motor vehicles, with several heating elements (12) assembled to form a heating block (11), a control unit (4) for activating the heating elements (12), the control unit (4) forming a structural unit with the heating block (11), and contact and/or cooling elements (18; 37) extending between the control unit (4) and the heating block (11),
**characterised in that**
the control unit (4) is retained on a control unit support (20) and, disposed between the control unit support (20) and a heating block housing (1) accommodating the heating block (11) are seal elements (41) through which the contact and cooling elements (18; 37) extend and which are sealed by a clamping action between the control unit support (20) and the heating block housing (1).

2. Electric heating device as claimed in claim 1, **characterised in that** the seal elements (41) lie against the circumferential surface of the contact and cooling elements (18; 37) due to a radial clamping action.

3. Electric heating device as claimed in one of the preceding claims, **characterised in that** the control unit support (20) and/or the heating block housing (1) has conical mounts (26) for the seal elements (41) which surround the passages (24) for the contact and cooling elements (18; 37), and the seal elements (41) are fixed between the heating block housing (1) and the control unit support (20) to create a sealing abutment against the internal circumferential surface of the mounts (26) and the external circumference of the contact and cooling elements (18; 37).

4. Electric heating device as claimed in one of the preceding claims, **characterised in that** the seal elements (41) are joined to one another to form an integral sealing unit (3).

5. Electric heating device as claimed in claim 4, **characterised in that** the seal elements (41) are joined to one another by means of a base portion (40).

6. Electric heating device as claimed in claim 5, **characterised in that** the base portion (40) is clamped to the edge of the passages (24) establishing a seal between the heating block housing (1) and the control unit support (20).

7. Electric heating device as claimed in claim 3, **characterised in that** the conical mounts (26) are surrounded by a protruding collar (25).

8. Electric heating device as claimed in one of the preceding claims, **characterised in that** the seal element (41) forms several seal contact surfaces (44) disposed one after the other in the longitudinal direction of the contact and cooling element (18; 37), which are disposed in a conically stepped arrangement with respect to one another.

9. Electric heating device as claimed in claim 8, **characterised in that** the seal contact surfaces (44) are formed by sealing beads (43) disposed one after the other.

10. Electric heating device as claimed in one of the preceding claims, **characterised in that** the heating block housing (1) forms window openings (16) for the cooling elements between the heating block (11) and the control unit (4) towards the side faces of the heating block housing (1), which are overlapped by a transverse web (46) affording a contact surface for the base portion (40).

11. Electric heating device as claimed in claim 10, **characterised in that** the transverse web (46) forms an essentially flat contact surface for the base portion (40).

12. Electric heating device as claimed in claim 10 or 11, **characterised in that** the transverse web (46) forms centring mounts (47) in which centring projections (42) formed on the base portion (40) are accommodated.

13. Electric heating device as claimed in claim 12, **characterised in that** the centring mounts (47) surround the passage (48) for the cooling and/or the contact element (18; 37).

14. Electric heating device as claimed in one of the preceding claims, **characterised in that** the control unit support (20) is part of a control unit housing (2), which has a housing cover (22) incorporating at least one interface (29; 31) for supplying and controlling the heating device and surrounds a circuit board (34) with cooling elements (37) extending down from it essentially at a right angle and electronic switches (36) and is connected to the heating block housing (1).

15. Electric heating device as claimed in claim 14, **characterised in that** the housing cover (22) has a contact rail (32) which is electrically connected to at least one of the interfaces (30b) and to the circuit board (34) and is positioned on the circuit board (34), the circuit board (34) has resilient lugs (35) cooperating with the contact elements (18) and the control unit housing (2) is supported on the heating block housing (1) by inserting the cooling and contact elements (18; 37) through the passages (24) and clamping the seal elements (41).

16. Electric heating device as claimed in one of the preceding claims, **characterised in that** the control unit support (20) is latched to the heating block housing (1).

17. Electric heating device as claimed in one of the preceding claims, **characterised in that** the seal element (41) is provided in the form of a heat-resistant, elastic material, in particular EPOM or silicone.

## Revendications

1. Dispositif de chauffage électrique, en particulier comme chauffage d'appoint pour véhicules automobiles, avec plusieurs éléments chauffants (12) réunis en un bloc chauffant (11), un dispositif de commande (4) pour commander les éléments chauffants (12), le dispositif de commande (4) formant avec le bloc chauffant (11) une unité de construction, et des éléments de contact et/ou de refroidissement (18 ; 37) qui s'étendent entre le dispositif de commande (4) et le bloc chauffant (11),
**caractérisé en ce que** le dispositif de commande (4) est fixé à un support de dispositif de commande (20), et **en ce qu'**il est prévu, entre le support de dispositif de commande (20) et une enveloppe de bloc chauffant (1) qui reçoit le bloc chauffant (11), des éléments d'étanchéité (41) qui sont traversés par les éléments de contact ou de refroidissement (18 ; 37) et qui sont rendus étanches en étant serrés entre le support de dispositif de commande (20) et l'enveloppe de bloc chauffant (1).

2. Dispositif de chauffage électrique selon la revendication 1, **caractérisé en ce que** les éléments d'étanchéité (41) sont appliqués contre la surface circonférentielle des éléments de contact ou de refroidissement (18 ; 37) grâce à un serrage radial.

3. Dispositif de chauffage électrique selon l'une des revendications précédentes, **caractérisé en ce que** le support de dispositif de commande (20) et/ou l'enveloppe de bloc chauffant (1) présentent des logements coniques (26) pour les éléments d'étanchéité (41), qui entourent des ouvertures de passage (24) pour les éléments de contact ou de refroidissement (18 ; 37), et **en ce que** les éléments d'étanchéité (41) destinés à produire une application étanche contre la surface circonférentielle intérieure des logements (26) et contre la circonférence extérieure des éléments de contact ou de refroidissement (18 ; 37) sont bloques entre l'enveloppe due bloc chauffant (1) et le support de dispositif de commande (20).

4. Dispositif de chauffage électrique selon l'une des revendications précédentes, **caractérisé en ce que** les éléments d'étanchéité (41) sont reliés entre eux pour former une unité d'étanchéité d'une seule pièce (3).

5. Dispositif de chauffage électrique selon la revendication 4, **caractérisé en ce que** les éléments d'étanchéité (41) sont reliés entre eux par une section de base (40).

6. Dispositif de chauffage électrique selon la revendication 5, **caractérisé en ce que** la section de base (40) est serrée de manière étanche contre le bord des ouvertures de passage (24), entre l'enveloppe de bloc chauffant (1) et le support de dispositif de commande (20)

7. Dispositif de chauffage électrique selon la revendication 3, **caractérisé en ce que** les logements coniques (26) sont entourés par une collerette saillante (25).

8. Dispositif de chauffage électrique selon l'une des revendications précédentes, **caractérisé en ce que** l'élément d'étanchéité (41) forme plusieurs surfaces d'application étanche (44) qui sont disposées les unes derrière les autres dans le sens longitudinal de l'élément de contact ou de refroidissement (18 ; 37) et qui présentent une disposition étagée en cône.

9. Dispositif de chauffage électrique selon la revendication 8, **caractérisé en ce que** les surfaces d'application étanche (44) sont formées par des renflements d'étanchéité (43) disposés les uns derrière les autres.

10. Dispositif de chauffage électrique selon l'une des revendications précédentes, **caractérisé en ce que** l'enveloppe de bloc chauffant (1) forme entre le bloc chauffant (11) et l'unité de commande (4), en direction des faces latérales de l'enveloppe de bloc chauffant (1), des fenêtres (16) pour les éléments de refroidissement, qui sont couvertes par une barre transversale (46) qui forme une surface d'application pour la section de base (40).

11. Dispositif de chauffage électrique selon la revendication 10, **caractérisé en ce que** la barre transversale (46) forme une surface d'application globalement plane pour la section de base (40).

12. Dispositif de chauffage électrique selon la revendication 10 ou 11, **caractérisé en ce que** la barre transversale (46) forme des logements de centrage (47) dans lesquels sont logées des saillies de centrage (42) formées sur la section de base (40).

13. Dispositif de chauffage électrique selon la revendication 12, **caractérisé en ce que** les logements de centrage (47) entourent l'ouverture de passage (48) pour l'élément de refroidissement et/ou de contact (18 ; 37).

14. Dispositif de chauffage électrique selon l'une des revendications précédentes, **caractérisé en ce que** le support de dispositif de commande (20) fait partie d'une enveloppe de dispositif de commande (2) qui comprend un couvercle d'enveloppe (22) présentant au moins une interface (29 ; 31) pour l'alimentation et la commande du dispositif de chauffage, qui entoure une carte imprimée (34) pourvue d'éléments de refroidissement (37) et de commutateurs (36) s'étendant globalement à angle droit à partir de ladite carte imprimée (34), et qui est reliée à l'enveloppe de bloc chauffant (1).

15. Dispositif de chauffage électrique selon la revendication 14, **caractérisé en ce que** le couvercle d'enveloppe (22) présente un rail de contact (32) qui est relié électriquement à l'une au moins des interfaces (30b) et à la carte imprimée (34) et qui est posé sur celle-ci, **en ce que** la carte imprimée (34) comprend des languettes élastiques (35) qui coopèrent avec les éléments de contact (18), et **en ce que** l'enveloppe de dispositif de commande (2) est montée sur l'enveloppe de bloc chauffant (1) grâce à l'introduction des éléments de refroidissement et de contact (18 ; 37) dans les ouvertures de passage (24), en serrant les éléments d'étanchéité (41).

16. Dispositif de chauffage électrique selon l'une des revendications précédentes, **caractérisé en ce que** le support de dispositif de commande (20) est relié par enclenchement à l'enveloppe de bloc chauffant (1).

17. Dispositif de chauffage électrique selon l'une des revendications précédentes, **caractérisé en ce que** l'élément d'étanchéité (41) est formé à partir d'un matériau résistant à la chaleur et élastique, en particulier d'EPOM ou de silicone.
